# EUROPÄISCHE PATENTANMELDUNG

(11) **EP 3 107 109 A1**
(43) Veröffentlichungstag der Anmeldung: **21.12.2016**
(21) Anmeldenummer: 16170611.4
(22) Anmeldetag: 20.05.2016
(51) Int. Cl.: H01H 9/54, H01H 33/59, H03K 17/74

(54) **GLEICHSTROMLEISTUNGSSCHALTER**

(30) Priorität: 19.06.2015 DE 102015211339
(71) Anmelder: Siemens Aktiengesellschaft, 80333 München (DE)
(72) Erfinder: Alvarez Valenzuela, Rodrigo Alonso, 90419 Nürnberg (DE); Döring, David, 91058 Erlangen (DE); Ergin, Dominik, 91083 Baiersdorf (DE); Schremmer, Frank, 90768 Fürth (DE); Schuster, Dominik, 91456 Diespeck (DE)

(57) **Zusammenfassung**

Die Erfindung bezieht sich auf einen Gleichstromleistungsschalter (10) zum Schalten eines entlang einer schalterbezogenen Hauptstromflussrichtung (FR) fließenden Gleichstroms (I) .

Erfindungsgemäß ist vorgesehen, dass der Gleichstromleistungsschalter (10) eine Reihenschaltung - nachfolgend Schalterreihenschaltung (R) genannt - mit einer Mehrzahl an elektrisch in Reihe geschalteten Halbleiterschaltelementen (21) aufweist und elektrisch parallel zu dieser Schalterreihenschaltung (R) ein Freilaufpfad (30) geschaltet ist, der unabhängig vom Schaltzustand der Halbleiterschaltelemente (21) einen Stromfluss entgegen der Hauptstromflussrichtung (FR) ermöglicht oder zumindest ermöglichen kann.

## Beschreibung

Die Erfindung bezieht sich auf einen Gleichstromleistungsschalter zum Schalten eines entlang einer Hauptstromflussrichtung fließenden Gleichstroms. Derartige Gleichstromleistungsschalter können beispielsweise bei Hochspannungs-Gleichstrom-Übertragungssystemen (abgekürzt HVDC-Systeme genannt) eingesetzt werden.

Ein Gleichstromleistungsschalter zum Einsatz bei Hochspannungs-Gleichstrom-Übertragungssystemen ist beispielsweise aus der Patentschrift EP 0 867 998 B1 bekannt.

Der Erfindung liegt die Aufgabe zugrunde, einen für einen Einsatz bei Hochspannungs-Gleichstrom-Übertragungssystemen geeigneten Gleichstromleistungsschalter anzugeben, der sich kostengünstig herstellen lässt und Strom zumindest in einer Richtung, nachfolgend Hauptstromflussrichtung genannt, schalten kann sowie Pulsströme entgegen der Hauptstromflussrichtung, beispielsweise im Falle von Ausgleichs- oder Entladeströmen, zerstörungsfrei überstehen kann.

Diese Aufgabe wird erfindungsgemäß durch einen Gleichstromleistungsschalter mit den Merkmalen gemäß Patentanspruch 1 gelöst. Vorteilhafte Ausgestaltungen des erfindungsgemäßen Gleichstromleistungsschalters sind in Unteransprüchen angegeben.

Danach ist erfindungsgemäß vorgesehen, dass der Gleichstromleistungsschalter eine Reihenschaltung - nachfolgend Schalterreihenschaltung genannt - mit einer Mehrzahl an elektrisch in Reihe geschalteten Halbleiterschaltelementen aufweist und elektrisch parallel zu dieser Schalterreihenschaltung ein Freilaufpfad geschaltet ist, der unabhängig vom Schaltzustand der Halbleiterschaltelemente einen Stromfluss entgegen der Hauptstromflussrichtung ermöglicht oder zumindest ermöglichen kann.

Ein wesentlicher Vorteil des erfindungsgemäßen Gleichstromleistungsschalters ist darin zu sehen, dass dieser zum Schalten in Reihe geschaltete Halbleiterschalterelemente aufweist und somit sehr kostengünstig herstellbar ist. Auf mechanische Schaltelemente kann somit vollständig verzichtet werden.

Ein weiterer wesentlicher Vorteil des erfindungsgemäßen Gleichstromleistungsschalters besteht darin, dass der erfindungsgemäß vorgesehene Freilaufpfad einen Schutz der Schalterreihenschaltung und damit einen Schutz der zu den Halbleiterschaltelementen üblicherweise parallel geschalteten Freilaufdioden gewährleistet. Auch im Falle einer sehr großen Pulsstrombelastung entgegen der Hauptstromflussrichtung kann der Freilaufpfad somit eine Zerstörung der Schalterreihenschaltung bzw. eine Zerstörung der zu den Halbleiterschaltelementen parallel geschalteten Freilaufdioden verhindern.

Bei den Halbleiterschaltelementen handelt es sich - mit Blick auf minimale Herstellungskosten - vorzugsweise um unidirektional schaltende Schalter, also Schalter, die einen Strom entlang der Hauptstromflussrichtung ein- und ausschalten können und entgegen dieser Hauptstromflussrichtung keine oder zumindest für den jeweiligen technischen Einsatz, insbesondere den Einsatz in Hochspannungs-Gleichstrom-Übertragungssystemen, keine ausreichenden Schalteigenschaften aufweisen.

Im Falle solcher unidirektional schaltender Halbleiterschalter ist der Freilaufpfad vorzugsweise derart ausgestaltet, dass er einen Stromfluss entgegen der Hauptstromflussrichtung an den Halbleiterschaltelementen vorbeilenkt.

Vorzugsweise handelt es sich bei den Halbleiterschaltelementen um Transistoren, insbesondere IGBTs, also Bipolartransistoren mit isolierter Gate-Elektrode, BIG(bi-mode insulated gate)-Transistoren oder IEGT(injection enhanced insulated gate bipolar)-Transistoren, oder alternativ um Thyristoren wie IGC(integrated gate-commutated)-Thyristoren.

Der Freilaufpfad weist, insbesondere für einen Einsatz bei hohen Gleichspannungen, vorzugsweise eine Vielzahl an elektrisch in Reihe geschalteten elektrischen Freilaufelementen auf.

Mit Blick auf ein effizientes Vorbeileiten von Pulsströmen, die entgegen der Hauptstromflussrichtung fließen, wird es als vorteilhaft angesehen, wenn die Schalterreihenschaltung zumindest eine Induktivität, insbesondere eine Drossel, aufweist, die einen entgegen der Hauptstromflussrichtung fließenden Strompuls in den Freilaufpfad lenkt.

Vorzugsweise ist zumindest eines der elektrischen Freilaufelemente eine Halbleiterdiode.

Falls der Freilaufpfad mehrere Halbleiterdioden umfasst, ist es vorteilhaft, wenn diese derart in Reihe geschaltet sind, dass ihre Durchlassrichtung jeweils entgegen der Hauptstromflussrichtung ausgerichtet ist.

Bezüglich der Ausgestaltung der Halbleiterdioden wird es als vorteilhaft angesehen, wenn die Halbleiterdioden jeweils eine Scheibenzellenbauform aufweisen und mechanisch mittels einer Spannvorrichtung aufeinander gepresste Einzeldioden umfassen. Eine Scheibenzellenbauform ermöglicht aufgrund der großflächigen Kontaktierung und aufgrund des Halbleiter-internen Aufbaus sehr hohe Impulsströme .

Vorzugsweise ist zu jedem der in Reihe geschalteten Halbleiterschaltelemente der Schalterreihenschaltung jeweils ein elektrisches Freilaufelement parallel geschaltet.

Mit Blick auf die Herstellung und Montage ist es vorteilhaft, wenn der Gleichstromleistungsschalter einen modularen Aufbau aufweist.

Im Falle eines modularen Aufbaus wird es als vorteilhaft angesehen, wenn jedes der Halbleiterschaltelemente mit jeweils einem zugeordneten Freilaufelement ein Teilmodul des Gleichstromleistungsschalters bildet und die Teilmodule unter Bildung der Schalterreihenschaltung und des Freilaufpfads elektrisch in Reihe geschaltet sind.

Besonders vorteilhaft ist es, wenn bei jedem Teilmodul zu jedem Halbleiterschaltelement jeweils eine moduleigene Freilaufdiode und ein Überspannungsableiter unter Bildung einer moduleigenen Parallelschaltung parallel geschaltet sind, mit der Parallelschaltung eine Induktivität, insbesondere Drossel, unter Bildung einer moduleigenen Reihenschaltung in Reihe geschaltet ist und ein Freilaufelement parallel zur moduleigenen Reihenschaltung geschaltet ist.

Bezüglich der Ausgestaltung der Freilaufelemente wird es als vorteilhaft angesehen, wenn die Strombelastbarkeit und/oder die Impulsstrombelastbarkeit der Freilaufelemente für einen Stromfluss entgegen der Hauptstromflussrichtung um ein Mehrfaches größer als die der Freilaufdioden ist und/oder die Freilaufelemente entgegen der Hauptstromflussrichtung niederohmiger als die Freilaufdioden sind.

Vorzugsweise ist bei jedem der Teilmodule zu jedem der Halbleiterschaltelemente jeweils eine moduleigene Freilaufdiode und - als Freilaufelement - jeweils eine Halbleiterdiode in Scheibenzellenbauform parallel geschaltet.

Wie bereits erwähnt, können die Freilaufelemente durch Halbleiterdioden gebildet sein; alternativ ist es möglich, elektrische Freilaufelemente durch Thyristoren zu bilden. Demgemäß wird es als vorteilhaft angesehen, wenn zumindest eines der elektrischen Freilaufelemente ein Thyristor ist, und zwar vorzugsweise ein solcher in Scheibenzellenbauform, der mechanisch mittels einer Spannvorrichtung aufeinander gepresste Einzelthyristoren umfasst.

Bezüglich der Ausgestaltung der Halbleiterschaltelemente wird es als vorteilhaft angesehen, wenn jedes der Halbleiterschaltelemente oder zumindest eines der Halbleiterschaltelemente durch eine Mehrzahl an parallel geschalteten Einzelschaltelementen gebildet ist.

Die Erfindung bezieht sich darüber hinaus auf ein Verfahren zum Schalten eines Gleichstroms. Bezüglich eines solchen Verfahrens ist erfindungsgemäß vorgesehen, dass mit einer Reihenschaltung mit einer Mehrzahl an elektrisch in Reihe geschalteten Halbleiterschaltelementen ein entlang einer Hauptstromflussrichtung fließender Strom ein- oder ausgeschaltet wird und mit einem elektrisch parallel zur Reihenschaltung geschalteten Freilaufpfad - unabhängig vom Schaltzustand der Halbleiterschaltelemente - ein entgegen der Hauptstromflussrichtung fließender Stromfluss an der Reihenschaltung vorbeigeleitet wird.

Bezüglich der Vorteile des erfindungsgemäßen Verfahrens sei auf die obigen Ausführungen im Zusammenhang mit dem erfindungsgemäßen Gleichstromleistungsschalter verwiesen, da die Vorteile des erfindungsgemäßen Gleichstromleistungsschalters denen des erfindungsgemäßen Verfahrens im Wesentlichen entsprechen.

Die Erfindung wird nachfolgend anhand von Ausführungsbeispielen näher erläutert; dabei zeigen beispielhaft:
- Figur 1: zur allgemeinen Erläuterung ein Ausführungsbeispiel für einen Gleichstromleistungsschalter, der keinen Freilaufpfad aufweist,
- Figur 2: ein Ausführungsbeispiel für einen Gleichstromleistungsschalter mit einem separaten Freilaufpfad auf der Basis von Halbleiterdioden,
- Figur 3: ein Ausführungsbeispiel für einen Gleichstromleistungsschalter mit einem in die Teilmodule des Gleichstromleistungsschalters integrierten Freilaufpfad auf der Basis von Halbleiterdioden,
- Figur 4: ein Ausführungsbeispiel für einen Gleichstromleistungsschalter mit separatem Freilaufpfad auf der Basis von Thyristoren,
- Figur 5: ein Ausführungsbeispiel für einen Gleichstromleistungsschalter mit in die Teilmodule des Gleichstromleistungsschalters integriertem Freilaufpfad auf der Basis von Thyristoren,
- Figur 6: ein Ausführungsbeispiel für ein bei den Gleichstromleistungsschaltern gemäß den Figuren 3 und 5 einsetzbares Teilmodul mit mehreren Einzelschaltelementen,
- Figur 7: ein Ausführungsbeispiel für ein bei den Gleichstromleistungsschaltern gemäß den Figuren 2 und 4 einsetzbares Teilmodul mit mehreren Einzelschaltelementen,
- Figur 8: ein Ausführungsbeispiel für ein bei den Gleichstromleistungsschaltern gemäß den Figuren 3 und 5 einsetzbares Teilmodul mit mehreren parallel geschalteten Schaltelementen, die jeweils mit einer zugeordneten Freilaufdiode fest verbaut sind, und
- Figur 9: ein Ausführungsbeispiel für ein bei den Gleichstromleistungsschaltern gemäß den Figuren 2 und 4 einsetzbares Teilmodul mit mehreren parallel geschalteten Schaltelementen, die jeweils mit einer zugeordneten Freilaufdiode fest verbaut sind.

In den Figuren werden der Übersicht halber für identische oder vergleichbare Komponenten stets dieselben Bezugszeichen verwendet.

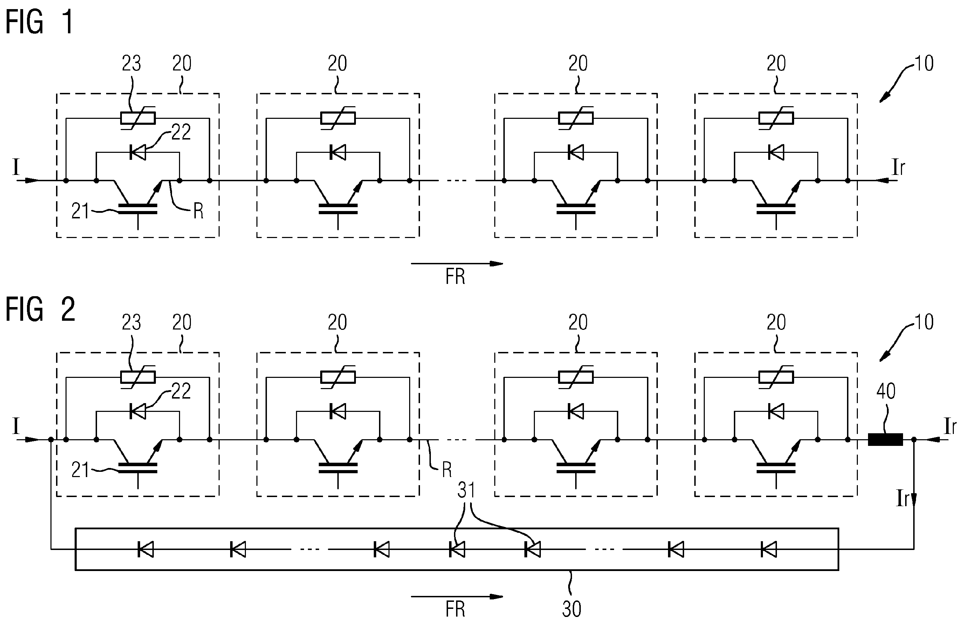

Die Figur 1 zeigt einen Gleichstromleistungsschalter 10, der eine Vielzahl an elektrisch in Reihe geschalteten Teilmodulen 20 aufweist. Jedes der Teilmodule 20 umfasst jeweils ein Halbleiterschaltelement 21, eine moduleigene und mit dem Halbleiterschaltelement 21 vorzugsweise mechanisch und elektrisch fest verbaute, insbesondere auf demselben Träger wie das Halbleiterschaltelement 21 befindliche Freilaufdiode 22 sowie einen moduleigenen Überspannungsableiter 23.

Bei den Halbleiterschaltelementen 21 handelt es sich um unidirektional schaltende Schalter, also um Schalter, die einen Strom lediglich in einer schaltereigenen Hauptstromflussrichtung FR ein- und ausschalten können. Bei der Darstellung gemäß Figur 1 sind die Halbleiterschaltelemente 21 des Gleichstromleistungsschalters 10 mit anderen Worten lediglich geeignet, den entlang der Hauptstromflussrichtung FR fließenden Gleichstrom I zu schalten.

Entgegen der Hauptstromflussrichtung FR sind die Halbleiterschaltelemente 21 nicht oder zumindest nicht ausreichend schaltfähig, da sie nur eingeschränkt in der Lage sind, in Rückwärtsrichtung Sperrspannung aufzunehmen. Bei den Halbleiterschaltelementen 21 kann es sich beispielsweise um IGBTs, also um Bipolartransistoren mit isolierter Gate-Elektrode, handeln.

Durch die Reihenschaltung der Teilmodule 20 sind auch die Halbleiterschaltelemente 21 elektrisch in Reihe geschaltet und bilden eine Reihenschaltung, die nachfolgend als Schalterreihenschaltung R bezeichnet wird.

Im Falle einer Pulsstrombelastung durch einen entgegen der Hauptstromflussrichtung FR fließenden Pulsstrom Ir werden die Halbleiterschaltelemente 21 bei dem Gleichstromleistungsschalter 10 gemäß Figur 1 durch die moduleigenen Freilaufdioden 22 kurzgeschlossen, die den entgegen der Hauptstromflussrichtung FR fließenden Pulsstrom Ir an dem jeweils zugeordneten Halbleiterschaltelement 21 vorbeileiten.

Im Falle eines sehr großen Pulsstromes Ir entgegen der Hauptstromflussrichtung FR werden die moduleigenen Freilaufdioden 22 elektrisch sehr hoch belastet, so dass es unter Umständen zu einer Zerstörung der moduleigenen Freilaufdioden 22 kommen kann.

Die Figur 2 zeigt ein Ausführungsbeispiel für einen Gleichstromleistungsschalter 10, bei dem zum Schutz der moduleigenen Freilaufdioden 22 ein separater Freilaufpfad 30 vorgesehen ist. Der Freilaufpfad 30 wird durch eine Vielzahl an elektrisch in Reihe geschalteten Freilaufelementen gebildet, bei denen es sich bei dem Ausführungsbeispiel gemäß Figur 2 um Halbleiterdioden 31 handelt.

Die Funktion des Freilaufpfades 30 besteht darin, im Falle einer Pulsbelastung durch einen entgegen der Hauptstromflussrichtung FR fließenden Pulsstrom Ir die Teilmodule 20 kurzzuschließen bzw. den Pulsstrom Ir an der Schalterreihenschaltung R bzw. der Reihenschaltung der Teilmodule 20 vorbeizuleiten.

Um zu erreichen, dass ein entgegen der Hauptstromflussrichtung FR fließender Pulsstrom Ir ganz oder zumindest überwiegend durch den Freilaufpfad 30 fließt und die Schalterreihenschaltung R bzw. die Reihenschaltung der moduleigenen Freilaufdioden 22 nicht oder zumindest nicht signifikant (also nicht in einer für die moduleigenen Freilaufdioden 22 zerstörerischen Höhe) mit dem Pulsstrom Ir belastet wird, ist bei dem Ausführungsbeispiel gemäß Figur 2 eine zusätzliche Drossel 40 vorgesehen. Die Drossel 40 ist für den transienten Pulsstrom Ir - wegen seiner Pulsform und dem damit sehr großen di/dt-Verhältnis (di/dt: Ableitung des Stromes nach der Zeit) - sehr hochohmig und sorgt somit dafür, dass der Pulsstrom Ir vornehmlich oder zumindest überwiegend in den demgegenüber niederohmigeren Freilaufpfad 30 fließen und an der Schalterreihenschaltung R bzw. der Reihenschaltung der Teilmodule 20 vorbeifließen wird.

Zusammengefasst sorgt der Freilaufpfad 30 mit den in Reihe geschalteten Halbleiterdioden 31 für einen effizienten Schutz der moduleigenen Freilaufdioden 22 im Falle einer Pulsstrombelastung durch einen entgegen der Hauptstromflussrichtung FR fließenden Pulsstrom Ir.

Um einen ausreichenden Schutz der Teilmodule 20 durch den Freilaufpfad 30 auch bei sehr großer Pulsstrombelastung bzw. bei sehr großen entgegen der Hauptstromflussrichtung FR fließenden Pulsströmen Ir zu gewährleisten, sind die Freilaufelemente bzw. die Halbleiterdioden 31 des Freilaufpfades 30 elektrisch derart dimensioniert bzw. ausgestaltet, dass ihre Strombelastbarkeit und/oder ihre Strompulsbelastbarkeit für den Pulsstrom Ir um ein Mehrfaches größer als die der moduleigenen Freilaufdioden 22 der Teilmodule 20 ist. Eine derartig hohe Strombelastbarkeit lässt sich in vorteilhafter Weise erreichen, wenn die Halbleiterdioden 31 jeweils eine Scheibenzellenbauform (auch Presspackbauform genannt) aufweisen und mechanisch, vorzugsweise mittels einer Spannvorrichtung, aufeinander gepresste Einzeldiodenscheiben umfassen.

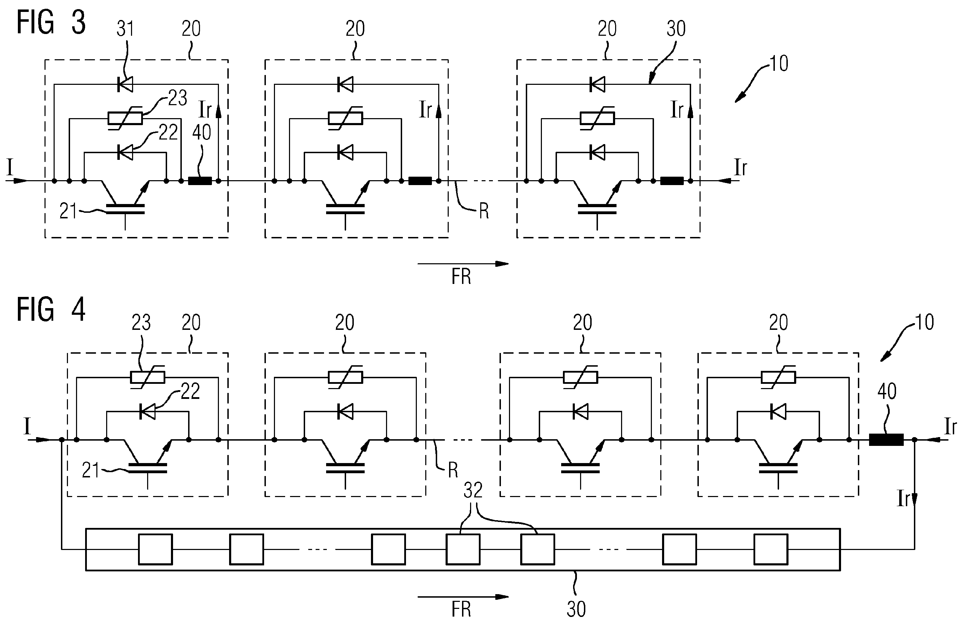

Die Figur 3 zeigt ein Ausführungsbeispiel für einen Gleichstromleistungsschalter 10, bei dem ein Freilaufpfad 30 in die Teilmodule 20 des Gleichstromleistungsschalters 10 integriert ist. So lässt sich erkennen, dass jedes der Teilmodule 20 jeweils mit einem Halbleiterschaltelement 21, einer moduleigenen Freilaufdiode 22, einem Überspannungsableiter 23 sowie zusätzlich mit einem moduleigenen Freilaufelement in Form einer Halbleiterdiode 31 ausgestattet ist. Die Dimensionierung der Halbleiterdiode 31 ist vorzugsweise derart gewählt, dass ihre Strombelastbarkeit und/oder ihre Strompulsbelastbarkeit für einen entgegen der Hauptstromflussrichtung FR fließenden Pulsstrom Ir deutlich größer ist als die der moduleigenen Freilaufdiode 22. Eine derartig hohe Strombelastbarkeit lässt sich bei den in den Teilmodulen integrierten Halbleiterdioden 31 erreichen, wenn diese eine Scheibenzellenbauform aufweisen und mechanisch, vorzugsweise mittels einer Spannvorrichtung, aufeinander gepresste Einzeldiodenscheiben umfassen.

Um zu gewährleisten, dass die moduleigenen Halbleiterdioden 31 einen entgegen der Hauptstromflussrichtung FR fließenden Pulsstrom Ir tatsächlich an der moduleigenen Freilaufdiode 22 - vornehmlich oder zumindest überwiegend - vorbeileiten, sind die Teilmodule 20 jeweils auch mit einer Drossel 40 ausgestattet, die für den transienten Pulsstrom Ir hochohmig ist und somit effektiv für eine Umleitung des Pulsstromes Ir in das moduleigene Freilaufelement in Form der Halbleiterdiode 31 sorgt.

Im Übrigen gelten die Erläuterungen im Zusammenhang mit den Figuren 1 und 2 bei dem Ausführungsbeispiel gemäß Figur 3 entsprechend. So lässt sich erkennen, dass die moduleigenen Freilaufelemente in Form der Halbleiterdioden 31 eine eigene Reihenschaltung und damit einen Freilaufpfad 30 bilden, der elektrisch parallel zu der aus den Halbleiterschaltelementen 21 der Teilmodule 20 gebildeten Schalterreihenschaltung R liegt.

Die Figur 4 zeigt ein Ausführungsbeispiel für einen Gleichstromleistungsschalter 10, der mit einem separaten Freilaufpfad 30 ausgestattet ist. Die Teilmodule 20 des Gleichstromleistungsschalters 10 entsprechen den Teilmodulen 20 bei dem Ausführungsbeispiel gemäß Figur 2.

Im Unterschied zu dem Ausführungsbeispiel gemäß Figur 2 ist der Freilaufpfad 30 bei dem Ausführungsbeispiel gemäß Figur 4 nicht mit Freilaufelementen in Form von Halbleiterdioden 31, sondern mit Freilaufelementen in Form von Thyristoren 32 ausgestattet. Die Thyristoren 32 sind in Reihe geschaltet und bilden gemeinsam den Freilaufpfad 30.

Die Thyristoren 32 sind derart ausgestaltet und werden derart angesteuert, dass im Falle einer Pulsstrombelastung durch einen entgegen der Hauptstromflussrichtung FR fließenden Pulsstrom Ir die Thyristoren 32 gezündet und durchgeschaltet werden, wodurch der Freilaufpfad 20 niederohmig wird und der Pulsstrom Ir an den moduleigenen Freilaufdioden 22 der Teilmodule 20 vorbeigeleitet wird, wie dies im Zusammenhang mit dem Ausführungsbeispiel gemäß Figur 2 oben erläutert worden ist.

Um einen ausreichenden Schutz der Teilmodule 20 durch den Freilaufpfad 30 auch bei sehr großer Pulsstrombelastung bzw. bei sehr großen entgegen der Hauptstromflussrichtung FR fließenden Pulsströmen Ir zu gewährleisten, sind die Thyristoren 32 des Freilaufpfades 30 elektrisch derart dimensioniert bzw. ausgestaltet, dass ihre Strombelastbarkeit und/oder ihre Strompulsbelastbarkeit für den Pulsstrom Ir um ein Mehrfaches größer als die der moduleigenen Freilaufdioden 22 der Teilmodule 20 ist. Eine derartig hohe Strombelastbarkeit lässt sich in vorteilhafter Weise erreichen, wenn die Thyristoren 32 jeweils eine Scheibenzellenbauform (auch Presspackbauform genannt) aufweisen und mechanisch, vorzugsweise mittels einer Spannvorrichtung, aufeinander gepresste Einzelthyristorscheiben umfassen.

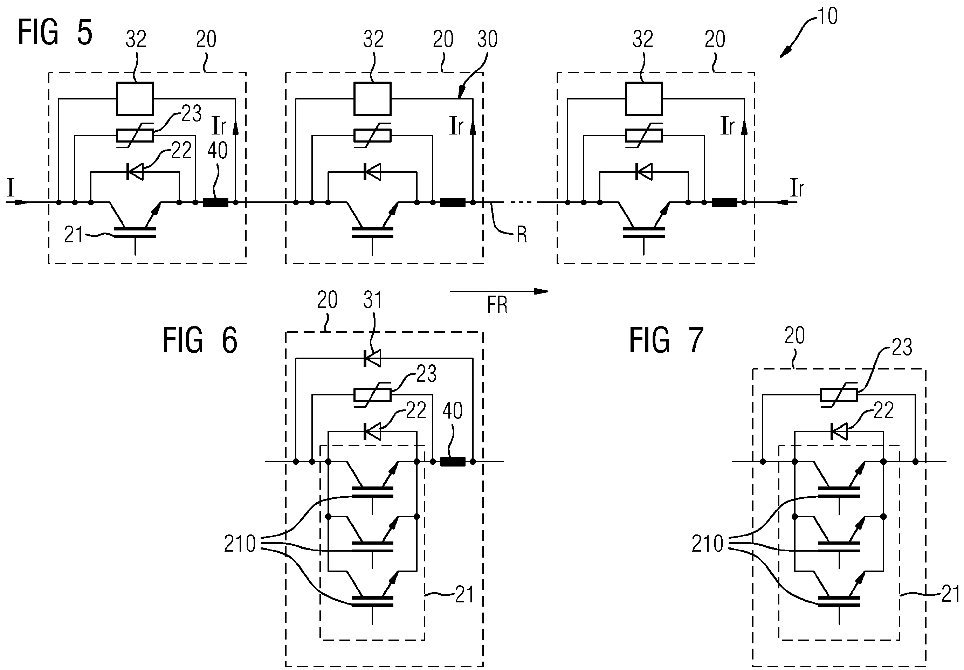

Die Figur 5 zeigt ein Ausführungsbeispiel für einen Gleichstromleistungsschalter 10, bei dem ein Freilaufpfad 30 in die Teilmodule 20 des Gleichstromleistungsschalters 10 integriert ist. Der Aufbau des Gleichstromleistungsschalters 10 gemäß Figur 5 entspricht im Wesentlichen dem Aufbau des Gleichstromleistungsschalters 10 gemäß Figur 3 mit dem Unterschied, dass die moduleigenen Freilaufelemente nicht durch Halbleiterdioden 31, wie bei dem Ausführungsbeispiel gemäß Figur 3, sondern stattdessen durch moduleigene Freilaufelemente in Form von Thyristoren 32 gebildet werden.

Kommt es zu einer Pulsstrombelastung durch einen entgegen der Hauptstromflussrichtung FR fließenden Pulsstrom Ir, so erfolgt eine Ansteuerung der Thyristoren 32 in den Teilmodulen 20 derart, dass die Thyristoren 32 gezündet bzw. durchgeschaltet werden, wodurch diese niederohmig werden und den Pulsstrom Ir an den moduleigenen Freilaufdioden 22 der Teilmodule 20 vorbeileiten.

Mit Blick auf einen hohen Wirkungsgrad beim Vorbeileiten des Pulsstromes Ir sind die Teilmodule 20 jeweils mit Drosseln 40 ausgestattet, deren Funktion und Wirkungsweise bereits im Zusammenhang mit der Figur 3 oben erläutert worden ist. Die Ausführungen zur Funktionsweise des Gleichstromleistungsschalters 10 gemäß Figur 3 gelten somit für das Ausführungsbeispiel gemäß Figur 5 entsprechend.

Die Figuren 6 und 7 zeigen beispielhaft, dass die Halbleiterschaltelemente 21, aufgrund der Forderung nach höheren DC-Lastströmen, durch eine Mehrzahl an parallel geschalteten Einzelschaltelementen gebildet sein können. Bei den Ausführungsbeispielen gemäß den Figuren 6 und 7 sind die Halbleiterschaltelemente 21 jeweils mit drei parallel geschalteten Einzelschaltelementen ausgestattet, die mit dem Bezugszeichen 210 gekennzeichnet sind. Bei den Einzelschaltelementen 210 kann es sich beispielsweise um IGBTs, also um Bipolartransistoren mit isolierter Gate-Elektrode, handeln.

Das Teilmodul 20 gemäß Figur 6 kann beispielsweise bei Gleichstromleistungsschaltern eingesetzt werden, bei denen der Freilaufpfad in die Teilmodule integriert ist, wie dies im Zusammenhang mit den Figuren 3 und 5 oben beispielhaft erläutert worden ist.

Das Teilmodul 20 gemäß Figur 7 wird vorzugsweise bei Gleichstromleistungsschaltern eingesetzt, die einen separaten Freilaufpfad aufweisen, wie dies oben beispielhaft im Zusammenhang mit den Ausführungsbeispielen gemäß den Figuren 2 und 4 erläutert worden ist.

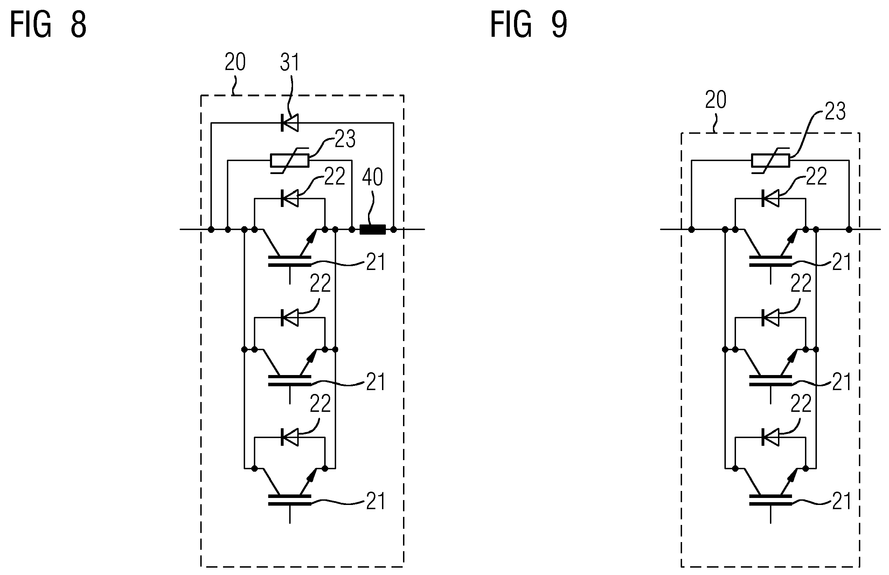

Die Figuren 8 und 9 zeigen beispielhaft Ausführungsvarianten für Teilmodule, bei denen jeweils mehrere Halbleiterschaltelemente 21 parallel geschaltet sind. Jedes Halbleiterschaltelement 21 ist jeweils mit einer zugeordneten bzw. eigenen, elektrisch parallel geschalteten Freilaufdiode 22 mechanisch und elektrisch fest verbaut; jede Freilaufdiode 22 befindet sich vorzugsweise auf demselben Träger wie das jeweils zugeordnete Halbleiterschaltelement 21.

Bei den Schaltelementen 21 kann es sich beispielsweise um IGBTs, also um Bipolartransistoren mit isolierter Gate-Elektrode, handeln.

Das Teilmodul 20 gemäß Figur 8 kann beispielsweise bei Gleichstromleistungsschaltern eingesetzt werden, bei denen der Freilaufpfad in die Teilmodule integriert ist, wie dies im Zusammenhang mit den Figuren 3 und 5 oben beispielhaft erläutert worden ist.

Das Teilmodul 20 gemäß Figur 9 wird vorzugsweise bei Gleichstromleistungsschaltern eingesetzt, die einen separaten Freilaufpfad aufweisen, wie dies oben beispielhaft im Zusammenhang mit den Ausführungsbeispielen gemäß den Figuren 2 und 4 erläutert worden ist.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Bezugszeichen
- 10: Gleichstromleistungsschalter
- 20: Teilmodul
- 21: Halbleiterschaltelement
- 22: moduleigene Freilaufdiode
- 23: moduleigener Spannungsableiter
- 30: Freilaufpfad
- 31: Halbleiterdiode
- 32: Thyristor
- 40: Drossel
- 210: Einzelschaltelement
- FR: Hauptstromflussrichtung
- I: Gleichstrom
- Ir: Pulsstrom
- R: Schalterreihenschaltung

## Patentansprüche

1. Gleichstromleistungsschalter (10) zum Schalten eines entlang einer Hauptstromflussrichtung (FR) fließenden Gleichstroms (I),
**dadurch gekennzeichnet, dass**
- der Gleichstromleistungsschalter (10) eine Reihenschaltung - nachfolgend Schalterreihenschaltung (R) genannt - mit einer Mehrzahl an elektrisch in Reihe geschalteten Halbleiterschaltelementen (21) aufweist und
- elektrisch parallel zu dieser Schalterreihenschaltung (R) ein Freilaufpfad (30) geschaltet ist, der unabhängig vom Schaltzustand der Halbleiterschaltelemente (21) einen Stromfluss entgegen der Hauptstromflussrichtung (FR) ermöglicht oder zumindest ermöglichen kann.

2. Gleichstromleistungsschalter (10) nach Anspruch 1, **dadurch gekennzeichnet, dass**
- die Halbleiterschaltelemente (21) unidirektional schaltende Schalter sind, die einen Strom entlang der Hauptstromflussrichtung (FR) ein- und ausschalten können, und
- der Freilaufpfad (30) einen Stromfluss entgegen der Hauptstromflussrichtung (FR) an den Halbleiterschaltelementen (21) vorbeilenkt.

3. Gleichstromleistungsschalter (10) nach einem der voranstehenden Ansprüche,
**dadurch gekennzeichnet, dass** der Freilaufpfad (30) eine Vielzahl an elektrisch in Reihe geschalteten elektrischen Freilaufelementen aufweist.

4. Gleichstromleistungsschalter (10) nach einem der voranstehenden Ansprüche,
**dadurch gekennzeichnet, dass** die Schalterreihenschaltung (R) zumindest eine Induktivität, insbesondere eine Drossel (40), aufweist, die einen entgegen der Hauptstromflussrichtung (FR) fließenden Strompuls in den Freilaufpfad (30) lenkt.

5. Gleichstromleistungsschalter (10) nach einem der voranstehenden Ansprüche,
**dadurch gekennzeichnet, dass** zumindest eines der elektrischen Freilaufelemente eine Halbleiterdiode (31) ist.

6. Gleichstromleistungsschalter (10) nach Anspruch 5,
**dadurch gekennzeichnet, dass** der Freilaufpfad (30) mehrere Halbleiterdioden (31) umfasst, die derart in Reihe geschaltet sind, dass ihre Durchlassrichtung jeweils entgegen der Hauptstromflussrichtung (FR) ausgerichtet ist.

7. Gleichstromleistungsschalter (10) nach einem der voranstehenden Ansprüche,
**dadurch gekennzeichnet, dass** die Halbleiterdioden (31) jeweils eine Scheibenzellenbauform aufweisen und mechanisch mittels einer Spannvorrichtung aufeinander gepresste Einzeldioden umfassen.

8. Gleichstromleistungsschalter (10) nach einem der voranstehenden Ansprüche,
**dadurch gekennzeichnet, dass** zu jedem der in Reihe geschalteten Halbleiterschaltelemente (21) der Schalterreihenschaltung (R) jeweils ein elektrisches Freilaufelement parallel geschaltet ist.

9. Gleichstromleistungsschalter (10) nach einem der voranstehenden Ansprüche,
**dadurch gekennzeichnet, dass**
- jedes der Halbleiterschaltelemente (21) mit jeweils einem zugeordneten Freilaufelement ein Teilmodul (20) des Gleichstromleistungsschalters (10) bildet und
- die Teilmodule (20) unter Bildung der Schalterreihenschaltung (R) und des Freilaufpfads (30) elektrisch in Reihe geschaltet sind.

10. Gleichstromleistungsschalter (10) nach einem der voranstehenden Ansprüche,
**dadurch gekennzeichnet, dass**
- bei jedem Teilmodul (20) zu jedem Halbleiterschaltelement (21) jeweils eine moduleigene Freilaufdiode (22) und ein Spannungsableiter unter Bildung einer moduleigenen Parallelschaltung parallel geschaltet sind,
- mit der Parallelschaltung eine Induktivität, insbesondere Drossel (40), unter Bildung einer moduleigenen Reihenschaltung in Reihe geschaltet ist und
- ein Freilaufelement parallel zur moduleigenen Reihenschaltung geschaltet ist.

11. Gleichstromleistungsschalter (10) nach einem der voranstehenden Ansprüche,
**dadurch gekennzeichnet, dass**
- die Strombelastbarkeit und/oder die Strompulsbelastbarkeit der Freilaufelemente für einen Stromfluss entgegen der Hauptstromflussrichtung (FR) um ein Mehrfaches größer als die der Freilaufdioden (22) ist und/oder
- die Freilaufelemente entgegen der Hauptstromflussrichtung (FR) niederohmiger als die Freilaufdioden (22) sind.

12. Gleichstromleistungsschalter (10) nach einem der voranstehenden Ansprüche,
**dadurch gekennzeichnet, dass** bei jedem der Teilmodule (20) zu jedem der Halbleiterschaltelemente (21) jeweils eine moduleigene Freilaufdiode (22) und
- als Freilaufelement - jeweils eine Halbleiterdiode (31) in Scheibenzellenbauform parallel geschaltet ist.

13. Gleichstromleistungsschalter (10) nach einem der voranstehenden Ansprüche,
**dadurch gekennzeichnet, dass** zumindest eines der elektrischen Freilaufelemente ein Thyristor (32) ist, und zwar vorzugsweise ein solcher in Scheibenzellenbauform, der mechanisch mittels einer Spannvorrichtung aufeinander gepresste Einzelthyristoren umfasst.

14. Gleichstromleistungsschalter (10) nach einem der voranstehenden Ansprüche,
**dadurch gekennzeichnet, dass** jedes der Halbleiterschaltelemente (21) oder zumindest eines der Halbleiterschaltelemente (21) durch eine Mehrzahl an parallel geschalteten Einzelschaltelementen (210) gebildet ist.

15. Verfahren zum Schalten eines Gleichstroms (I), **dadurch gekennzeichnet, dass**
- mit einer Reihenschaltung mit einer Mehrzahl an elektrisch in Reihe geschalteten Halbleiterschaltelementen (21) ein entlang einer Hauptstromflussrichtung (FR) fließender Strom ein- oder ausgeschaltet wird und
- mit einem elektrisch parallel zur Reihenschaltung geschalteten Freilaufpfad (30) - unabhängig vom Schaltzustand der Halbleiterschaltelemente (21) - ein entgegen der Hauptstromflussrichtung (FR) fließender Stromfluss an der Reihenschaltung vorbeigeleitet wird.
